**Europäisches Patentamt**

**European Patent Office**

**Office européen des brevets**

(19)

(11) Veröffentlichungsnummer: **0 173 833 B1**

# EUROPÄISCHE PATENTSCHRIFT

(12)

(45) Veröffentlichungstag der Patentschrift: **09.12.92**

(51) Int. Cl.⁵: **G01K 1/02**, G01K 17/00, G01K 7/24

(21) Anmeldenummer: **85108822.9**

(22) Anmeldetag: **15.07.85**

(54) **Schaltung und Verfahren zur Messung und Digitalisierung eines Widerstandes.**

(30) Priorität: **06.09.84 CH 4254/84**

(43) Veröffentlichungstag der Anmeldung:
**12.03.86 Patentblatt 86/11**

(45) Bekanntmachung des Hinweises auf die
Patenterteilung:
**09.12.92 Patentblatt 92/50**

(84) Benannte Vertragsstaaten:
**DE FR GB IT**

(56) Entgegenhaltungen:
DE-A- 2 024 925   DE-A- 2 356 837
DE-A- 3 129 476   DE-A- 3 130 499
FR-A- 2 155 979   FR-A- 2 377 730
US-A- 3 786 350   US-A- 4 117 722

FUNKSCHAU, Band 14, 1983, Seiten 37-38,
Franzis-Verlag, München, DE; R. STARZNER:
"Mikrovolt messen"

ELEKTRONIK, Nr. 12, 1974, Seiten 469-472,
Franzis-Verlag, München, DE; R.C. KIME et
al.: "'Charge balancing' - ein neues
A/D-Integrationsverfahren"

(73) Patentinhaber: **Mettler-Toledo AG**
**Im Langacher**
**CH-8606 Greifensee(CH)**

(72) Erfinder: **Baumann, Arthur**
**Hertistrasse 11**
**CH-8614 Bertschikon(CH)**

**EP 0 173 833 B1**

## Beschreibung

Die Erfindung betrifft ein Verfahren eine Schaltung zur Messung und Digitalisierung eines Widerstandswertes, insbesondere desjenigen eines Temperaturfühlers, umfassend einen A/D-Wandler zur Erzeugung des digitalisierten Messwertes, mit einem Integrator und einem dem Integrator nachgeschalteten Komparator.

Konventionelle Schaltungen dieser Art umfassen regelmässig offene Systeme, das heisst, dem Analog-/Digital-Wandler (A/D-Wandler) wird das Signal eines Messwertaufnehmers zugeführt, ohne dass eine Rückkopplung bzw. Rückführung vom Wandler zur Sensorschaltung stattfindet. Dies wird beispielsweise deutlich im Artikel 'Mikrovolt messen' (Funkschau 14/1983, 5.37/38), in welchem ein A/D-Wandler-Baustein nach dem Ladungsausgleichsprinzip (Charge Balancing, im folgenden kurz ChB genannt) beschrieben ist, an dessen Eingang das Signal beispielsweise eines Temperaturfühlers gelegt werden kann. Das ChB-Verfahren selbst ist bekannt z.B. aus 'Elektronik', Heft 12/1974, Seiten 469-472, und der US-Patentschrift 3,790,886. Spezielle Temperaturmessschaltungen dieser Art sind bekannt aus den deutschen

Offenlegungsschriften 31 29 476 sowie 31 30 499. Beide verwenden ebenfalls ein 'offenes' System aus Messwertaufnehmer und A/D-Wandler. Darüber hinaus liegen in beiden Fällen keine reinen Verhältnismessungen von Widerständen vor: Im einen Fall gehen die Widerstände der Schalter, welche den Referenz- bzw. den Messwiderstand an den A/D-Wandler anschalten, in die Messung ein (31 29 476). Im anderen Fall (31 30 499) ist es die Kapazität eines Kondensators, die in die Messwertermittlung eingeht und die Genauigkeit des Ergebnisses zu beeinträchtigen vermag.

Aus der Patentschrift US-A-4,117,722 ist eine Temperaturmessschaltung bekannt, welche zur Erzeugung eines digitalen Messsignales eine temperatur-proportionale Frequenz heranzieht, welche in üblicher Weise ausgezählt wird. Diese bekannte Schaltung umfasst unter anderem eine Referenzspannungsquelle und eine Konstantstromquelle. Diese Bestandteile wirken auf die Messwertgewinnung bzw. -digitalisierung ein und müssen daher bei hohen Anforderungen an die Messgenauigkeit bzw. -auflösung sehr präzise und stabil sein.

Die Druckschrift US-A-3,786,350 beschreibt ein Widerstandsmessgerät mit digitaler Anzeige. Aehnlich wie bei der vorgenannten US-A-4,117,722 wird die Grösse des zu messenden Widerstandes durch eine dieser Grösse proportionale Frequenz dargestellt. Die zur Messung dienende Brückenschaltung umfasst einen elektronischen Schalter, dessen Widerstand temperaturabhängig ist, wodurch die Messgenauigkeit begrenzt ist.

Die vorliegende Erfindung hatte sich die Aufgabe gestellt, unter weitestgehender Ausschaltung möglicher Fehlerquellen eine Schaltung und ein Verfahren bereitzustellen, mit denen sehr präzise und einer hohen Messwertauflösung zugängliche Widerstandsmessungen, insbesondere von Temperaturfühlern, möglich sind.

Gemäss der Erfindung ist hierzu eine entsprechende Schaltung dadurch gekennzeichnet, dass der zu messende Widerstand sowohl Bestandteil des nach dem Ladungsausgleichsprinzip arbeitenden A/D-Wandlers als auch Bestandteil eines Widerstandsnetzwerkes ist, das Widerstände bekannter Grösse umfasst, welche zusammen mit dem zu messenden Widerstand die Grösse des den Integrator ladenden bzw. entladenden Stroms bestimmen, und dass eine Schaltung zur Aufbereitung eines integrierten Messwertes aus einer Mehrzahl von gemessenen Widerstandswerten vorgesehen ist.

Dieses Konzept bedeutet u.a., dass Messwertaufnehmer und A/D-Wandler zu einem 'geschlossenen' System verschmolzen sind: Wie anhand der weiter unten folgenden Beschreibung deutlich wird, wirkt der A/D-Wandler auf die Beschaltung des Messwiderstandes zurück. Diese Tatsache, in Verbindung mit der Integration mehrerer Einzelwerte zu einem Messergebnis, bewirkt die angestrebte hohe Resultatauflösung. Ausserdem hat das vorliegende Konzept den Vorteil, ohne hochgenaue Referenzen für Spannung bzw. Strom auszukommen; es werden lediglich Präzisionswiderstände benötigt, welche bei vergleichbarer Langzeitstabilität wesentlich billiger sind.

Es ist üblich, den Komparator eines ChB-Wandlers gegen ein festes Potential arbeiten zu lassen. Dies würde jedoch bedeuten, dass die einzelnen Wandlungsintervalle unterschiedliche Längen abhängig vom Messwert hätten. Es wird daher eine Ausbildung bevorzugt, bei der der Komparator an eine periodische Sägezahnspannung geschaltet ist. Diese Ausführungsform erlaubt das Arbeiten mit festen zeitlichen Intervallen, was wiederum Vorteile bei der Aufbereitung des digitalen Messwertes hat. So ist eine die Qualität des Messergebnisses weiter verbessernde digitale Filterung einfacher möglich.

Für Fälle, in denen verschiedene Messwiderstände erfasst werden sollen, sieht eine Weiterbildung der Schaltung vor, dass zusätzliche Schalter vorgesehen sind, die ein Umschalten zwischen mehreren Messwiderständen erlauben. Damit könnten beispielsweise mehrere Temperaturmessstellen in einem Wärmeflusskalorimeter erfasst werden.

Die Erfindung betrifft ferner ein Verfahren der eingangs genannten Art, bei welchem ein von der Grösse des Widerstandes abhängiger, von einer vorgegebenen Spannung bestimmter Strom $i_x$ als Mass für die Grösse des Widerstandes verwendet und mittels des Ladungsausgleichsprinzips in einen digitalen Wert gewandelt wird, welches dadurch gekennzeichnet ist, dass der den zu messenden Widerstand dauernd durchfliessende Strom $i_x$ während einer ersten, durch eine Rückkopplung gesteuerten Teilzeit von einer Speisespannung und während einer zweiten Teilzeit von der zur Digitalisierung dienenden Ladungsausgleichsschaltung aufrecht erhalten wird.

Vorzugsweise ist dieses Verfahren so ausgestaltet, dass eine Zeitgeberschaltung zeitliche Intervalle konstanter Grösse erzeugt, die in eine erste und eine zweite Teilzeit aufgeteilt werden, dass der Strom $i_x$ alternierend während der ersten Teilzeit von einer Speisespannung bezogen und während der zweiten Teilzeit teilweise vom Integrator der Ladungsausgleichsschaltung abgezogen wird, dass während der ersten Teilzeit ein ebenfalls von der Speisespannung bezogener Strom $i_1$ in den Integrator fliesst, dessen Ausgangsspannung in einem Komparator mit einer periodischen Sägezahnspannung verglichen wird, dass während der ersten oder der zweiten Teilzeit über eine Torschaltung hochfrequente Taktimpulse in eine Zähl- und Auswerteschaltung gelangen, wobei die Summe der Taktimpulse ein Mass für die Grösse des Widerstandes bildet, und dass für die Darstellung der Grösse des Widerstandes eine Mehrzahl von Taktimpulssummen ausgewertet wird.

Ein Ausführungsbeispiel der Erfindung wird nachstehend anhand der Zeichnungen erläutert. In den Zeichnungen ist

Figur 1   eine schematische Darstellung der konventionellen Anordnungen,

Figur 2   eine schematische Darstellung der Anordnung gemäss der Erfindung,

Figur 3   ein Schaltbild des Ausführungsbeispiels,

Figur 4   ein Signaldiagramm, und

Figur 5   eine Variante zu Figur 3.

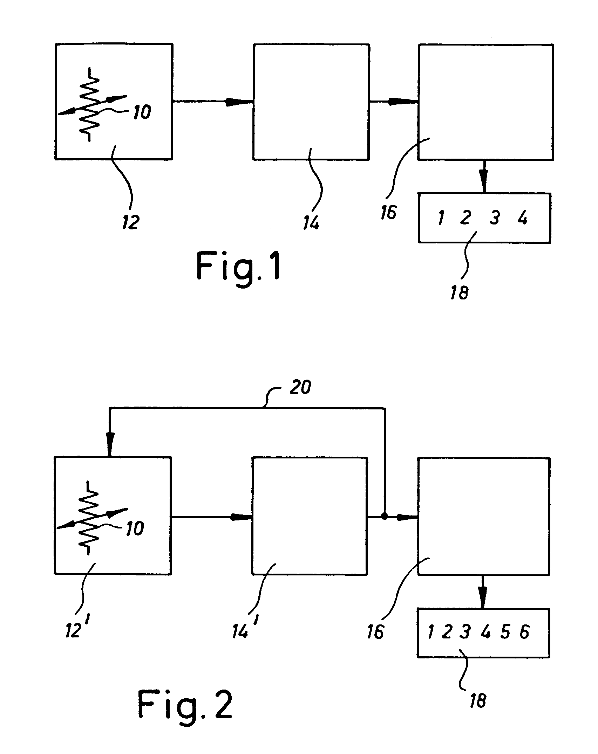

Das Schema der Figur 1 veranschaulicht bekannte Anordnungen: Ein zu messender Widerstand 10 ist Bestandteil einer Sensorschaltung 12. Das erzeugte analoge Messsignal gelangt in einen A/D-Wandler 14. Das resultierende digitale Messsignal wird in einer Schaltung 16, gegebenenfalls nach Vornahme von Korrekturen, zur Darstellung in einer Digitalanzeige 18 aufbereitet. Bei der konventionellen Methode ist die Erzeugung und Umformung (z.B. Verstärkung) des analogen Messsignals unabhängig von der anschliessenden Wandlung in eine digitale Grösse, d.h. es handelt sich um ein offenes System.

Anders gemäss der Erfindung. Hier wirkt die digitalisierte Grösse auf die Erzeugung und Aufbereitung des analogen Messsignals zurück, symbolisiert in Figur 2 durch eine Rückführungsleitung 20. Es ergibt sich ein geschlossenes System (12', 14', 20) nach Art eines Regelkreises, welches - im Gegensatz zu offenen Systemen - Störungen aus Verstärkern und anderen Bauteilen unterdrückt (Störungen bzw. Fehler, die auch durch Integration vieler Einzelwerte in offenen Systemen nicht ausgeschaltet werden können!).

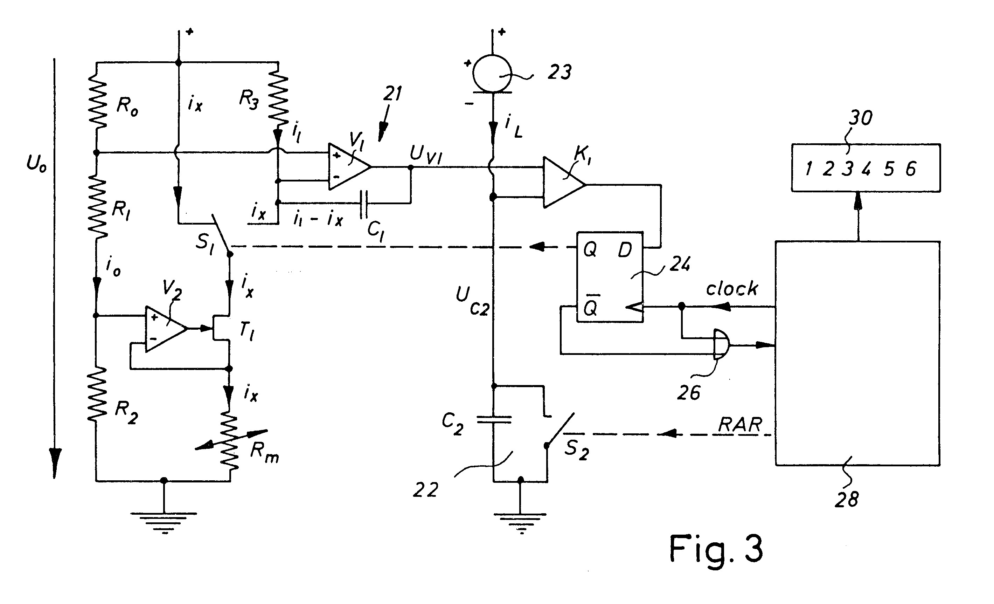

Figur 3 zeigt den Aufbau der Schaltung eines Ausführungsbeispiels. Ein Widerstandsnetzwerk umfasst in Reihe zwei Präzisionswiderstände $R_o$ und $R_2$ und dazwischen einen Widerstand $R_1$, der nicht besonders genau sein muss. Parallel zu diesen Widerständen ist eine zweite Reihe geschaltet, bestehend aus einem Präzisionswiderstand $R_3$ und dem Messwiderstand $R_m$ (im vorliegenden Fall ein Temperaturfühler in einem Kalorimeter). Das Netzwerk liegt an einer Betriebsspannung $U_o$. In seinem unteren Teil ist eine Stromsenke vorgesehen (Differenzverstärker $V_2$, Feldeffekttransistor $T_1$). Im oberen Teil ist ein Integrator 21 angeschlossen (Differenzverstärker $V_1$, Kondensator $C_1$). Zwischen $R_3$ und $T_1$ ist ein Schalter $S_1$ vorgesehen, der alternierend entweder den Strompfad zwischen $R_3$ und $R_m$ oder zwischen dem Pluspol und $R_m$ schliesst. Dem Ausgang des Integrators 20 ist ein Komparator $K_1$ nachgeschaltet, dessen zweiter Eingang an einem Sägezahnspannungsgenerator 22 liegt (Stromquelle 23, Kondensator $C_2$, Schalter $S_2$). Der Ausgang des Komparators $K_1$ ist an den D-Eingang eines Flipflop 24 geführt, welches synchron zur Taktfrequenz (clock) den Schalter $S_1$ und ein Tor 26 steuert. Mit 28 ist der Digitalteil der Schaltung bezeichnet, welcher u.a. einen Oszillator für die Taktimpulse (clock), einen Zeitgeber für den Sägezahnspannungsgenerator 22 (Signal RAR = ramp reset), eine Zähl- und Rechenschaltung sowie die Ansteuerung für eine Digitalanzeige 30 umfasst. Der Aufbau des Digitalteils 28, dessen wesentlichen Kern ein entsprechend programmierter Mikrocomputer bildet, ist nicht Bestandteil der Erfindung, sondern konventionell gestaltet und bedarf daher keiner Erläuterung.

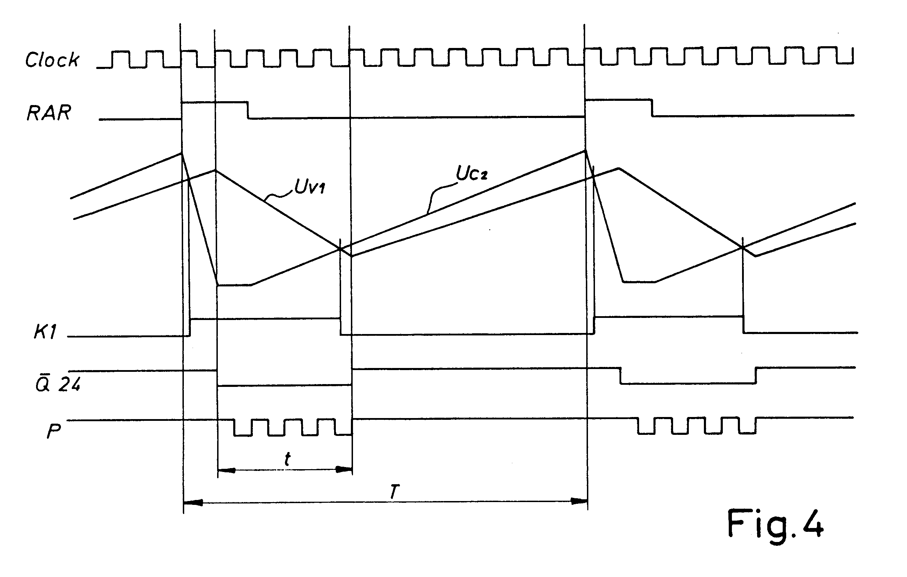

Anhand des Signaldiagramms der Figur 4 sei nun die Arbeitsweise der Schaltung beschrieben.

Zu Beginn einer einzelnen Messperiode (Rampe) T wird mit dem Signal RAR der Schalter $S_2$ des Sägezahngenerators 22 für eine festgelegte kurze Zeitspanne geschlossen (z.B. 16 Taktimpulse). In dieser Zeitspanne sinkt die Sägezahnspannung $U_{C2}$ auf Null ab. Dabei unterschreitet sie die Ausgangsspannung $U_{V1}$ des Integrators 21. In diesem Moment kippt der Ausgang des Komparators $K_1$ auf logisch Eins und bringt über das Flipflop 24 mit dem nächsten Taktimpuls

- den Schalter $S_1$ in die in Figur 3 gezeichnete Stellung, und
- öffnet das Tor 26.

Dies bedeutet, dass

- in den Integrator 21 ein Strom $i_1$ fliesst, so dass dessen Ausgangsspannung $U_{V1}$ linear abfällt,
- der den Messwiderstand $R_m$ durchfliessende, diesem proportionale Strom $i_x$ von der Betriebsspannung gezogen wird, und
- Taktimpulse P durch das Tor 26 in die Zählschaltung des Digitalteils 28 gelangen.

Sobald die Spannung $U_{V1}$ die Sägezahnspannung $U_{C2}$ unterschreitet, kippt der Ausgang des Komparators $K_1$ auf logisch Null. Dies bewirkt über den Flipflop 24, dass auf den nächsten Taktimpuls

- das Tor 26 geschlossen und
- der Schalter $S_1$ umgeschaltet wird.

Nun wird der Integrator 21 mit dem Strom $i_1 - i_x$ ($i_x > i_1$!) entladen (die Stromsenke $V_2$, $T_1$ zieht den Strom $i_x$ teilweise aus dem Integrator 21 ab), und die Ausgangsspannung $U_{V1}$ steigt wieder linear an, bis der Zyklus nach Abschluss der Periode T mit dem Signal RAR reu beginnt.

Man erkennt das Funktionsprinzip des charge balancing: Im Mittel wird dem Integrator 21 gleich viel Ladung zugeführt (Strom $i_1.t$) wie entzogen (Strom $(i_1 - i_x).(T-t)$ mit $i_x > i_1$).

Die während der Zeitspanne t gezählten Taktimpulse P sind ein Mass für den unbekannten Widerstand $R_m$. Wie sich leicht ableiten lässt, ergibt sich die Grösse des Widerstandes $R_m$ aus der Formel

$$R_m = \frac{R_2 . R_3}{R_0} . \frac{T - t}{T}$$

das heisst, es findet eine reine Verhältnismessung statt, in der nur die Werte der Präzisionswiderstände $R_0$, $R_2$ und $R_3$ sowie die Zeitabschnitte T und t vorkommen. Auf einfache Weise und mit einfachen Mitteln wird also eine genaue Messung ermöglicht.

Zur weiteren Verbesserung der Genauigkeit und zur Erzielung der gewünschten hohen Auflösung des Ergebnisses werden die Einzelsummen der Taktimpulse P aus einer Mehrzahl von Perioden T aufsummiert und anschliessend, nach in bekannter Manier im Mikrocomputer vorgenommener Filterung und Linearisierung sowie Rundung, als Resultat zur Anzeige 30 übermittelt.

Einige approximative Zahlenwerte mögen zur Verdeutlichung beitragen:

- Taktfrequenz (clock) 5 MHz
- Periode T 1 ms (wobei maximal nutzbar ca. 4.000 Impulse je Periode)
- Anzahl Perioden je Resultat: 1.000, d.h. Rohergebnis 4 Millionen Punkte, Anzeigeumfang (nach Rundung) 400.000 Punkte.

Damit konnte z.B. ein digitales Thermometer in einem Bereich von - 100 bis + 200° mit einer Auflösung von 0,001° realisiert werden.

Es versteht sich, dass die genannten Zahlenwerte (Taktfrequenz, Periodendauer, Anzahl Perioden je Resultat) je nach den Gegebenheiten in einem weiten Rahmen variiert werden können.

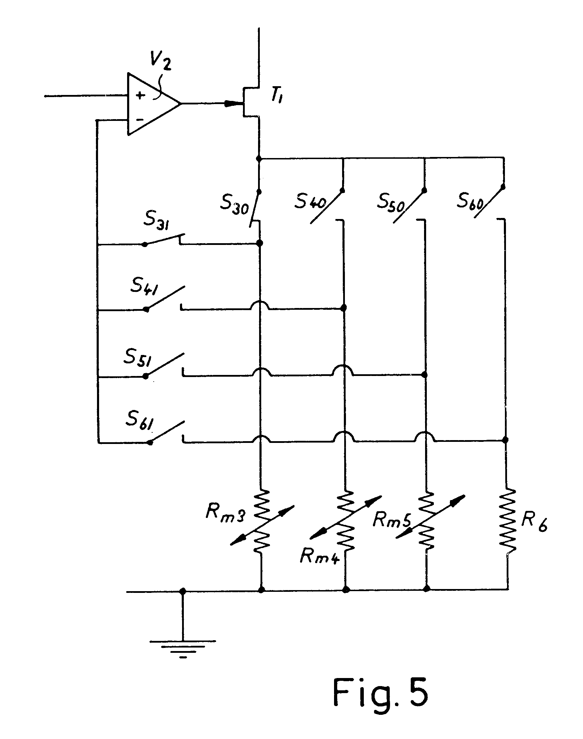

In Figur 5 ist eine Variante vorgestellt. Sie erlaubt bei im übrigen praktisch unverändertem Aufbau der Schaltung (lediglich die Steuerprogramme im Digitalteil müssen entsprechend angepasst werden) durch Einfügen einiger zusätzlicher Schalter ein Umschalten zwischen verschiedenen Messwiderständen.

Drei Messwiderstände $R_{m3}$, $R_{m4}$ und $R_{m5}$ sind über je ein Schalterpaar $S_{30}$, $S_{31}$ bzw. $S_{40}$, $S_{41}$ bzw. $S_{50}$, $S_{51}$ mit der Stromsenke $V_2$, $T_1$ verknüpft. Zusätzlich ist ein Präzisionswiderstand $R_6$ mit Schaltern $S_{60}$, $S_{61}$ vorgesehen, mit dessen Hilfe eine Kalibrierung vorgenommen werden kann (bei der Kalibrierung soll sich über eine Mehrzahl von Messperioden (Rampen) ein vorgegebener Wert für die Zeitspanne t einstellen).

Wie in Figur 5 ersichtlich, ist jeweils nur dasjenige Schalterpaar geschlossen (z.B. $S_{30}$, $S_{31}$) das zum gerade zu messenden Widerstand gehört; alle anderen Schalter sind offen. Die Widerstände der Schalter bleiben ohne Einfluss auf das Resultat. Die Schaltersteuerung wird in bekannter Weise durch Signale der Zeitgeberschaltung des Digitalteils 28 vorgenommen (nicht gezeichnet), was durch entsprechendes Programmieren des Mikrocomputers geschehen kann. Ein typischer Anwendungsfall dieser Variante wäre z.B. die abwechselnde Erfassung mehrerer Temperaturmessstellen in einem System.

Bei entsprechender Anpassung der Auswerterechnungen im Digitalteil 28 können sowohl die Zeit t (wie im obigen Beispiel) als auch die Zeit (T - t) zur Zählung der Taktimpulse P herangezogen werden.

**Patentansprüche**

1. Schaltung zur Messung und Digitalisierung eines Widerstandswertes, insbesondere desjenigen eines Temperaturfühlers, umfassend einen A/D-Wandler zur Erzeugung des digitalisierten Messwertes, mit einem Integrator und einem dem Integrator nachgeschalteten Komparator, dadurch gekennzeichnet, dass der zu messende Widerstand ($R_m$) sowohl Bestandteil des nach dem Ladungsausgleichsprinzip arbeitenden A/D-Wandlers als auch Bestandteil eines Widerstandsnetzwerkes ist, das Widerstände bekannter Grösse $R_0$, $R_2$ und $R_3$ umfasst, welche zusammen mit dem zu messenden Widerstand ($R_m$) die Grösse sowohl des den Integra-

tor (21) ladenden Stroms ($i_1$) wie auch des den Integrator entladenden Stroms ($i_1-i_x$) bestimmen, und dass eine Schaltung (28) zur Aufbereitung eines integrierten Messwertes aus einer Mehrzahl von gemessenen Widerstandswerten vorgesehen ist.

2. Schaltung nach Anspruch 1, dadurch gekennzeichnet, dass der Komparator ($K_1$) des A/D-Wandlers an eine periodische Sägezahnspannung ($U_{C2}$) geschaltet ist.

3. Schaltung nach Anspruch 1 oder 2, dadurch gekennzeichnet, dass zusätzliche Schalter ($S_{30}$, $S_{31}$...$S_{60}$, $S_{61}$) vorgesehen sind, die ein Umschalten zwischen mehreren Messwiderständen ($R_{m3}$...$R_{m5}$) erlauben.

4. Verfahren zur Messung eines elektrischen Widerstandes, insbesondere eines Temperaturfühlers, bei welchem ein von der Grösse des Widerstandes abhängiger, von einer vorgegebenen Spannung bestimmter Strom $i_x$ als Mass für die Grösse des Widerstandes verwendet und mittels des Ladungsausgleichsprinzips in einen digitalen Wert gewandelt wird, wobei der den zu messenden Widerstand ($R_m$) dauernd durchfliessende Strom $i_x$ während einer ersten, durch eine Rückkopplung gesteuerten Teilzeit von einer Speisespannung und während einer zweiten Teilzeit von der zur Digitalisierung dienenden Ladungsausgleichsschaltung aufrecht erhalten wird.

5. Verfahren nach Anspruch 4, dadurch gekennzeichnet,
  - dass eine Zeitgeberschaltung (28) zeitliche Intervalle konstanter Grösse erzeugt, die in eine erste und eine zweite Teilzeit aufgeteilt werden,
  - dass der Strom $i_x$ alternierend
    - während der ersten Teilzeit von einer Speisespannung bezogen und
    - während der zweiten Teilzeit teilweise vom Integrator (21) der Ladungsausgleichsschaltung abgezogen wird,
  - dass während der ersten Teilzeit ein ebenfalls von der Speisespannung bezogener Strom $i_1$ in den Integrator fliesst, dessen Ausgangsspannung in einem Komparator ($K_1$) mit einer periodischen Sägezahnspannung ($U_{C2}$) verglichen wird,
  - dass während der ersten oder der zweiten Teilzeit über eine Torschaltung (26) hochfrequente Taktimpulse in eine Zähl- und Auswerteschaltung (28) gelangen, wobei die Summe der Taktimpulse ein Mass für die Grösse des Widerstandes bildet, und
  - dass für die Darstellung der Grösse des Widestandes eine Mehrzahl von Taktimpulssummen ausgewertet wird.

**Claims**

1. A circuit for the measurement and digitisation of a resistance value, in particular that of a temperature sensor, comprising an A/D-converter for producing the digitised measurement value, with an integrator and a comparator connected downstream of the integrator, characterised in that the resistance ($R_m$) to be measured is both a component of the A/D-converter which operates on the charge balancing principle and also a component of a resistance network which includes resistors of known magnitude $R_0$, $R_2$ and $R_3$ which together with the resistance ($R_m$) to be measured determine the magnitude both of the current ($i_1$) charging the integrator (21) and also the current ($i_1-i_x$) discharging the integrator, and that there is provided a circuit (28) for producing an integrated measurement value from a plurality of measured resistance values.

2. A circuit according to claim 1 characterised in that the comparator ($K_1$) of the A/D-converter is connected to a periodic sawtooth voltage ($U_{C2}$).

3. A circuit according to claim 1 or claim 2 characterised in that there are provided additional switches ($S_{30}$, $S_{31}$ ...$S_{60}$, $S_{61}$) which permit switching over between a plurality of resistances ($R_{m3}$... $R_{m5}$) to be measured.

4. A process for measuring an electrical resistance, in particular of a temperature sensor, wherein a current $i_x$ which is dependent on the magnitude of the resistance and which is determined by a predetermined voltage is used as a measurement in respect of the magnitude of the resistance and converted into a digital value by means of the charge balancing principle, wherein the current $i_x$ which continuously flows through the resistance ($R_m$) to be measured is maintained by a feed voltage during a first period which is controlled by a feedback and is maintained during a second period by the charge balancing circuit which serves for digitisation purposes.

5. A process according to claim 4 characterised in that
  - a timer circuit (28) produces time intervals of constant magnitude which are divided into first and second periods,

- the current $i_x$ is alternately
  - obtained from a feed voltage during the first period, and
  - partly taken from the integrator (21) of the charge

  balancing circuit during the second period,
- a current $i_1$ which is also obtained from the feed voltage flows during the first period into the integrator, the output voltage of which is compared in a comparator ($K_1$) to a periodic sawtooth voltage ($U_{C2}$),
- during the first or the second period high-frequency clock pulses pass into a counting and evaluation circuit (28) by way of a gate circuit (26), the sum of the clock pulses forming a measurement in respect of the magnitude of the resistance, and
- a plurality of clock pulse sums is evaluated for representation of the magnitude of the resistance.

## Revendications

1. Circuit de mesure et de numérisation de la valeur d'une résistance, en particulier de celle d'un palpeur de température, comprenant un convertisseur analogique/numérique de génération de la mesure numérisée, ainsi qu'un intégrateur et un comparateur monté en aval de l'intégrateur, caractérisé en ce que la résistance à mesurer ($R_m$) fait partie d'une part du convertisseur analogique/numérique fonctionnant selon le principe de l'équilibrage de charge et d'autre part d'un réseau de résistances qui comprend des résistances de valeur connue $R_0$, $R_2$ et $R_3$ qui déterminent avec la résistance à mesurer ($R_m$) l'intensité aussi bien du courant ($i_1$) qui charge l'intégrateur (21) que du courant ($i_1 - i_x$) qui décharge l'intégrateur, et en ce qu'un montage (28) de traitement d'une mesure résultant de l'intégration de plusieurs valeurs mesurées de résistance est prévu.

2. Circuit selon la revendication 1, caractérisé en ce que le comparateur ($K_1$) du convertisseur analogique/numérique est branché sur une tension périodique en dents de scie ($U_{C2}$).

3. Circuit selon la revendication 1 ou 2, caractérisé en ce que des interrupteurs supplémentaires ($S_{30}$, $S_{31}...S_{60}$, $S_{61}$) qui sont prévus permettent une commutation entre plusieurs résistances à mesurer ($R_{m3}...R_{m5}$).

4. Procédé de mesure d'une résistance électrique, en particulier de celle d'un palpeur de température, suivant lequel un courant $i_x$ qui est fonction de la valeur de la résistance et qui est déterminé par une tension prescrite est utilisé en mesure de la valeur de la résistance et converti en une valeur numérique d'après le principe de l'équilibrage de charge, procédé suivant lequel le courant $i_x$ circulant en permanence dans la résistance ($R_m$) à mesurer est entretenu au moyen d'une tension d'alimentation pendant un premier sous-intervalle de temps commandé par une réaction et, pendant un second sous-intervalle de temps, au moyen du circuit d'équilibrage de charge servant à la numérisation.

5. Procédé selon la revendication 4, caractérisé
   - en ce qu'un circuit d'horloge (28) génère des intervalles de temps de valeur constante qui sont subdivisés en un premier et un second sous-intervalle de temps,
   - en ce que le courant $i_x$ est tiré en alternance
     - pendant le premier sous-intervalle de temps, d'une tension d'alimentation et
     - pendant le second sous-intervalle de temps, partiellement sur l'intégrateur (21) du circuit d'équilibrage de charge,
   - en ce que, pendant le premier sous-intervalle de temps, un courant $i_1$ également tiré sur la tension d'alimentation circule dans l'intégrateur dont la tension de sortie est comparée dans un comparateur ($K_1$) à une tension périodique en dents de scie ($U_{C2}$),
   - en ce que des impulsions d'horloge à haute fréquence parviennent pendant le premier ou le second sous-intervalle de temps par l'intermédiaire d'un circuit de porte (26) dans un circuit de comptage et d'évaluation (28), la somme des impulsions d'horloge formant une mesure de la valeur de la résistance et
   - en ce que plusieurs sommes d'impulsions d'horloge sont analysées pour la représentation de la valeur de la résistance.

Fig.1

Fig.2

Fig. 3

EP 0 173 833 B1

Fig.4

EP 0 173 833 B1

Fig. 5